# EUROPEAN PATENT APPLICATION

(11) **EP 4 712 758 A1**
(43) Date of publication of application: **18.03.2026**
(21) Application number: 25188714.7
(22) Date of filing: 10.07.2025
(51) Int. Cl.: H10W 70/692, H10W 70/62

(54) **METHODS AND APPARATUS FOR PACKAGE SUBSTRATES WITH STACKS OF GLASS LAYERS INCLUDING INTERCONNECT BRIDGES**

(30) Priority: 12.09.2024 US 202418883807
(71) Applicant: Intel Corporation, Santa Clara, CA 95054 (US)
(72) Inventor: DUAN, Gang, Chandler, 85248 (US); LIU, Minglu, Chandler, 85248 (US); RAMANUJA PIETAMBARAM, Srinivas Venkata, Chandler (US)
(74) Representative: Viering, Jentschura & Partner mbB Patent- und Rechtsanwälte

(57) **Abstract**

Systems, apparatus, articles of manufacture, and methods for package substrates with stacks of glass layers including interconnect bridges are disclosed. An example substrate for an integrated circuit package includes: a first glass layer having a cavity defined therein; a second glass layer different from the first glass layer; and an interconnect bridge at least partially in the cavity. The interconnect bridge electrically couples a first semiconductor die to a second semiconductor die.

## Description

### BACKGROUND

Integrated circuit (IC) chips and/or semiconductor dies are routinely connected to larger circuit boards such as motherboards and other types of printed circuit boards (PCBs) via a package substrate. As IC chips and/or dies reduce in size and interconnect densities increase, alternatives to traditional substrate layers are being developed to provide stable transmission of high-frequency data signals between different circuitry and/or increased power delivery. One option being pursued is the implementation of package substrates with glass cores. Generally, glass core implementations offer several advantages compared to implementations with conventional epoxy cores, including a higher plated through-hole (PTH) density, lower signal losses, and lower total thickness variation.

### BRIEF DESCRIPTION OF THE DRAWINGS

FIG. 1 illustrates an example integrated circuit (IC) package constructed in accordance with teachings disclosed herein.
FIG. 2 illustrates an example package substrate that may be used to implement the example package substrate of FIG. 1.
FIGS. 3-10 illustrate different stages in an example fabrication process to manufacture the example package substrate of FIG. 2.
FIG. 11 illustrates another example package substrate that may be used to implement the example package substrate of FIG. 1.
FIG. 12 is a flowchart representative of an example method that may be performed to fabricate any one of the example package substrates of FIGS. 1-11.
FIG. 13 is a top view of a wafer including dies that may be included in an IC package constructed in accordance with teachings disclosed herein.
FIG. 14 is a cross-sectional side view of an IC device that may be included in an IC package constructed in accordance with teachings disclosed herein.
FIG. 15 is a cross-sectional side view of an IC device assembly that may include an IC package constructed in accordance with teachings disclosed herein.
FIG. 16 is a block diagram of an example electrical device that may include an IC package constructed in accordance with teachings disclosed herein.
In general, the same reference numbers will be used throughout the drawing(s) and accompanying written description to refer to the same or like parts. The figures are not necessarily to scale. Instead, the thickness of the layers or regions may be enlarged in the drawings. Although the figures show layers and regions with clean lines and boundaries, some or all of these lines and/or boundaries may be idealized. In reality, the boundaries and/or lines may be unobservable, blended, and/or irregular.

### DETAILED DESCRIPTION

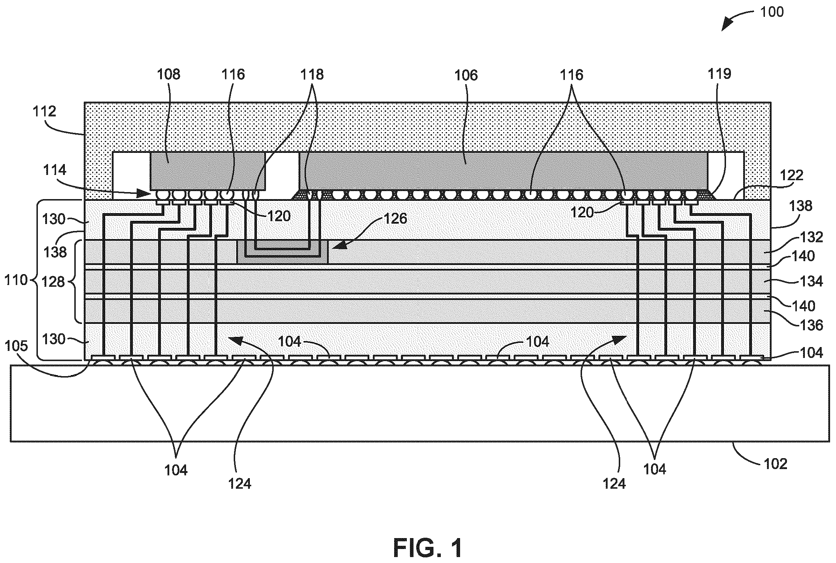

FIG. 1 illustrates an example integrated circuit (IC) package 100 constructed in accordance with teachings disclosed herein. In the illustrated example, the IC package 100 is electrically coupled to a circuit board 102 via an array of contacts 104 on a package mounting surface 105 (e.g., a bottom surface, an external surface) of the package. In the illustrated example, the contacts 104 are represented as pads or lands. However, in some examples, the IC package 100 may include balls, pins, and/or any other type of contact, in addition to or instead of the pads or lands shown to enable the electrical coupling of the IC package 100 to the circuit board 102. In this example, the IC package 100 includes two semiconductor (e.g., silicon) dies 106, 108 (sometimes also referred to as chips or chiplets) that are mounted to a package substrate 110 and enclosed by a package lid 112 (e.g., a mold compound, an integrated heat spreader (IHS), etc.). Thus, the package substrate 110 is an example means for supporting a semiconductor die. While the example IC package 100 of FIG. 1 includes two dies 106, 108, in other examples, the IC package 100 may have only one die or more than two dies. In some examples, one of the dies 106, 108 (or a separate die) is embedded in the package substrate 110. The dies 106, 108 can provide any suitable type of functionality (e.g., data processing, memory storage, etc.).

As shown in the illustrated example, each of the dies 106, 108 is electrically and mechanically coupled to the package substrate 110 via corresponding arrays of interconnects 114. In FIG. 1, the interconnects are shown as bumps. However, the interconnects 114 may be any other type(s) of electrical connection in addition to or instead of the bumps shown (e.g., balls, pins, pads, wire bonding, etc.). The electrical connections between the dies 106, 108 and the package substrate 110 (e.g., the interconnects 114) are sometimes referred to as first level interconnects. By contrast, the electrical connections between the IC package 100 and the circuit board 102 (e.g., the contacts 104) are sometimes referred to as second level interconnects. In some examples, one or both of the dies 106, 108 may be stacked on top of one or more other dies and/or an interposer. In such examples, the dies 106, 108 are coupled to the underlying die and/or interposer through a first set of first level interconnects and the underlying die and/or interposer may be connected to the package substrate 110 via a separate set of first level interconnects associated with the underlying die and/or interposer. Thus, as used herein, first level interconnects refer to interconnects (e.g., balls, bumps, pins, pads, wire bonding, etc.) between a die and a package substrate or a die and an underlying die and/or interposer.

As shown in FIG. 1, the interconnects 114 of the first level interconnects include two different types of bumps corresponding to core bumps 116 and bridge bumps 118. As used herein, the core bumps 116 are bumps on the dies 106, 108 through which electrical signals pass between the dies 106, 108 and components external to the IC package 100. More particularly, as shown in the illustrated example, when the dies 106, 108 are mounted to the package substrate 110, the core bumps 116 are physically connected and electrically coupled to contacts 120 (e.g., pads, bumps, etc.) on an die mounting surface 122 (e.g., an upper, an inner surface, an internal surface, a top surface, etc.) of the package substrate 110. The contacts 120 on the die mounting surface 122 of the package substrate 110 are electrically coupled to the contacts 104 on the package mounting surface 105 (e.g., the bottom, external surface) of the package substrate 110 (e.g., a surface opposite the die mounting surface 122) via internal interconnects 124 within the package substrate 110. As a result, there is a continuous electrical signal path between the core bumps 116 of the dies 106, 108 and the contacts 104 mounted to the circuit board 102 that pass through the contacts 120 and the interconnects 124 provided therebetween. As shown, the package mounting surface 105 and the die mounting surface 122 define opposing outer surfaces of the package substrate 110. While both surfaces are outer surfaces of the package substrate 110, the die mounting surface 122 is sometimes referred to herein as an internal or inner surface relative to the overall IC package 100. By contrast, in this example, the package mounting surface 105 is an outer or exterior surface of the IC package 100.

As used herein, the bridge bumps 118 are bumps on the dies 106, 108 through which electrical signals pass between different ones of the dies 106, 108 within the IC package 100. Thus, as shown in the illustrated example, the bridge bumps 118 of the first die 106 are electrically coupled to the bridge bumps 118 of the second die 108 via an interconnect bridge 126 (e.g., a silicon-based interconnect bridge, an interconnect die, an embedded interconnect bridge (EMIB)) embedded in the package substrate 110. As represented in FIG. 1, core bumps 116 are typically larger than bridge bumps 118. In some examples, the bridge bumps 118 are smaller than the core bumps to enable finer pitch or line spacing of interconnects provided in the interconnect bridge 126 than is possible using interconnects within known organic-based package substrates. In some examples, as shown in FIG. 1, the interconnect bridge is embedded within the substrate core 128 (e.g., within the first glass core 132). In some examples, the interconnect bridge 126 includes through-silicon vias (TSVs) to electrically couple with ones of the contacts 104 (e.g., via ones of the interconnects 124) on the package mounting surface 105 of the package substrate 110.

In some examples, an underfill material 119 is disposed between the dies 106, 108 and the package substrate 110 around and/or between the first level interconnects 114 (e.g., around and/or between the core bumps 116 and/or the bridge bumps 118). In the illustrated example, only the first die 106 is associated with the underfill material 119. However, in other examples, both dies 106, 108 are associated with the underfill material 119. In other examples, the underfill material 119 is omitted. In some examples, the mold compound used for the package lid 112 is used as an underfill material that surrounds the first level interconnects 114.

In some examples, the IC package 100 includes additional passive components, such as surface-mount resistors, capacitors, and/or inductors disposed on the package mounting surface 105 of the package substrate 110 and/or the die mounting surface 122 of the package substrate 110.

In FIG. 1, the substrate 110 of the example IC package 100 includes a substrate core 128 (e.g., a main core, an overall core) between two separate build-up layers or regions 130, 131 (e.g., redistribution layers or regions). As shown in the illustrated example, the substrate core 128 includes multiple distinct glass cores (e.g., multiple glass layers, multiple glass core layers, etc.), namely an example top glass core 132 (e.g., a first glass core), an example middle glass core 134 (e.g., a second glass core), and an example bottom glass core 136 (e.g., a third glass core). In the illustrated example of FIG. 1, the glass cores 132, 134, 136 (e.g., sub-cores, glass substrates, glass layers, glass sheets) are stacked on top of one another.

In some examples, the cores 132, 134, 136 include at least one of: aluminosilicate, borosilicate, alumino-borosilicate, silica, and/or fused silica. In some examples, the cores 132, 134, 136 include one or more additives including: aluminum oxide (Al₂O₃), boron trioxide (B₂O₃), magnesia oxide (MgO), calcium oxide (CaO), stoichiometric silicon oxide (SrO), barium oxide (BaO), stannic oxide (SnO₂), nickel alloy (Na₂O), potassium oxide (K₂O), phosphorus trioxide (P₂O₃), zirconium dioxide (ZrO₂), lithium oxide (Li₂O), titanium (Ti), and/or zinc (Zn). In some examples, the cores 132, 134, 136 include silicon and oxygen. In some examples, the cores 132, 134, 136 include silicon, oxygen and/or one or more of aluminum, boron, magnesium, calcium, barium, tin, sodium, potassium, strontium, phosphorus, zirconium, lithium, titanium, and/or zinc. In some examples, the cores 132, 134, 136 include at least 23 percent silicon by weight and at least 26 percent oxygen by weight. In some examples, the glass cores 132, 134, 136 are individual layers of glass including silicon, oxygen, and aluminum. In some examples, the cores 132, 134, 136 include at least 23 percent silicon by weight, at least 26 percent oxygen by weight, and at least 5 percent aluminum by weight. In some examples, as discussed further below, different ones of the glass cores 132, 134, 136 include different materials or different compositions of materials so that the different glass cores 132, 134, 136 are associated with different coefficients of thermal expansion (CTE). In some examples, the CTE is modified between the different glass cores 132, 134, 136 by changing the amount of alkali dopants (e.g., Na₂O, K₂O, etc.) included in the glass. In general, the lower the alkali content, the lower the CTE. Thus, for a CTE of 3 ppm/°C, the alkali content may be less than 0.1%. By contrast, for a CTE of 9 ppm/°C, the alkali content can be up to 20%.

In some examples, the cores 132, 134, 136 are amorphous solid glass layers. In some examples, the cores 132, 134, 136 are layers of glass that do not include an organic adhesive or an organic material. In some examples, the cores 132, 134, 136 are solid layers of glass having a rectangular shape in plan view. In some examples, the cores 132, 134, 136, as glass substrates, include at least one glass layer and do not include epoxy and do not include glass fibers (e.g., do not include an epoxy-based prepreg layer with glass cloth). In some examples, the cores 132, 134, 136 correspond to single pieces of glass that extend the full height/thickness of each corresponding core.

In some examples, the cores 132, 134, 136 have a rectangular shape that is substantially coextensive, in plan view, with the layers above and/or below the core. In some examples, the cores 132, 134, 136 have a thickness in a range of about 25 micrometers (µm) to about 400 µm (with the overall thickness of the substrate core 128 ranging from about 50 µm to about 1.4 millimeters (mm)). In some examples, the cores 132, 134, 136 can have dimensions of about 10 mm on a side to about 250 mm on a side (e.g., 10 mm by 10 mm to 250 mm by 250 mm). In some examples, the cores 132, 134, 136 correspond to rectangular prism volumes with sections (e.g., vias) removed and filled with other materials (e.g., metal).

The build-up regions 130, 131 are represented in FIG. 1 as masses/blocks with the internal interconnects 124 extending in straight lines through the build-up regions 130, 131 (and the glass cores 132, 134, 136). However, FIG. 1 has been simplified for the sake of clarity and purposes of explanation. In practice, the interconnects are not necessarily straight. More particularly, in some examples, the build-up regions 130, 131 are defined by alternating layers of dielectric material and layers of conductive material (e.g., a metal such as copper). The conductive (metal) layers serve as the basis for the internal interconnects 124 represented, in a simplified form, by straight lines as shown in FIG. 1. In some examples, the metal layers are patterned to define electrical routing or conductive traces that are electrically coupled between different metal layers by conductive (e.g., metal) vias extending through intervening dielectric layers. Further, the electrical routing or traces on either side of the substrate core 128 may be electrically coupled by through-glass vias (TGVs) (e.g., copper plated vias) extending through the glass cores 132, 134, 136.

In some examples, one or both of the build-up regions 130, 131 may be omitted. That is, in some examples, the stack of glass cores 132, 134, 136 defines most (e.g., all or substantially all) of the thickness of the package substrate 110 (e.g., all except for outer solder resist layers, all except for a reduced set of metallization layers in the build-up regions 130, 131, etc.). In some such examples, the stack of glass cores 132, 134, 136 includes more than three glass layers and the redistribution of electrical paths defined by the interconnects 124 is achieved by traces or routing running parallel to and between adjacent ones of the glass layers. Further, in some examples, as shown in FIG. 1, the interconnect bridge 126 is embedded with the uppermost glass core 132 to provide die-to-die connections, thereby reducing and/or eliminating the need for the upper build-up region 130. That is, in some examples, by embedding the interconnect bridge 126 within the uppermost glass core 132, fewer metallization layers with intervening dielectric layers are needed in the upper build-up region 130 than would otherwise be possible. In some examples, the upper build-up region 130 can be entirely omitted.

Among other things, glass cores are advantageous over epoxy-based cores because glass is stiffer and, therefore, provides for greater mechanical support or strength for the package substrate. Thus, the substrate core 128 and, more particularly, the individual glass cores 132, 134, 136 are example means for strengthening the package substrate. In addition to mechanical benefits, glass cores also provide other advantages including a higher plated through-hole (PTH) density, lower signal losses, and a lower total thickness variation.

Although the above advantages may be realized in disclosed examples, glass cores also present challenges due to the fragile (e.g., brittle) nature of glass and the possibility of defects that can develop into cracks that propagate through the glass. A common type of failure of known glass cores is referred to as a seware failure. Seware failures result in the separation of a glass core along a crack that propagates from an edge of the glass core along its length and width between the main outer surfaces (e.g., upper and lower surfaces, front and back surfaces) of the glass core. That is, seware failures are characterized by a glass core being split into two separate sheets of glass along a line extending generally parallel to the main plane of the glass core.

Factors that contribute to seware failures include defects on the edges of glass cores resulting from singulation and the internal stress induced by a mismatch in coefficient of thermal expansion (CTE) between the glass core (e.g., a CTE of around 3 ppm/°C to 10 ppm/°C) and the material in the build-up regions (e.g., a CTE of around 39 ppm/°C for the organic dielectric layers, a CTE of around 17 ppm/°C for the copper, and a CTE around 2.6 ppm/°C for silicon) during thermal cycles of the package substrate 110 (either during the fabrication process or during use thereafter). More particularly, package substrates, such as the package substrate 110 of FIG. 1, are often fabricated on a large panel that is subsequently singulated or cut into individual units with a saw. Thus, in the illustrated example of FIG. 1, the package substrate 110, including the substrate core 128 (and the associated sub-cores 132, 134, 136) and the build-up regions 130, 131, include opposing edges 138 that are created by the cut of a saw. Such sawing can result in defects developing on the edges of glass cores (e.g., the edges 138 of the glass cores 132, 134, 136 in FIG. 1) that can give rise to cracks that propagate laterally across the middle of the glass core to split the glass core into two main pieces. The development and propagation of cracks in this manner is exacerbated by stress induced by fluctuations in temperature and the difference in CTE of the build-up regions relative to the CTE of the glass core. Generally, the material in the build-up regions 130, 131 has a higher CTE than glass. As a result, the material in the build-up regions 130, 131 expands and contracts more than a glass core in response to thermal fluctuations, thereby causing internal stress within the glass core that can promote crack propagation.

Examples disclosed herein reduce (e.g., minimize) concerns for seware failures by implementing the substrate core 128 of the substrate with multiple distinct (e.g., disaggregated) glass cores (e.g., the glass cores 132, 134, 136) stacked on top of one another as shown in FIG. 1. More particularly, in examples disclosed herein, the different stacked cores are implemented by different materials (or different compositions of the same materials) associated with different CTEs. That is, in some examples, the different CTEs of different glass cores 132, 134, 136 can be tuned by tailoring (e.g., modifying, changing, etc.) the relative proportions of Al₂O₃, B₂O₃, Li₂O, Na₂O, K₂O, Sb₂O₃, and/or other additives in each of the layers and/or via processing variations (e.g., lamination cladding, thermal treatment, etc.). In some examples, the glass cores that are closer to the build-up regions 130, 131 are fabricated with a CTE that is closer to the CTE of the build-up regions 130, 131 than the CTE of the glass cores farther away from the build-up regions 130, 131 (e.g., closer to the middle of the stack of glass cores). In this manner, the substrate core 128 is defined by a gradation of CTEs or incremental changes in CTE across a larger span of CTE values (e.g., across the glass core 132, 134, 136 in the stack) to provide a smoother transition between the different layers in the package substrate 110, thereby reducing stress at any given location.

For instance, in some examples, the middle glass core 134 has a lower CTE than the top glass core 132 and a lower CTE than the bottom glass core 136. In some examples, the CTE of the top glass core 132 and the bottom glass core 136 are the same. Thus, in some examples, the different CTEs of the glass cores 132, 134, 136 are symmetrical across the overall thickness of the substrate core 128. That is, the arrangement or ordering of the stack of glass cores 132, 134, 136 and their associated CTEs define a symmetric sequence of CTEs (e.g., a symmetrical CTE gradient) from a lowermost glass core (e.g., the third glass core 136) to an uppermost glass core (e.g., the first glass core 132). In some such examples, the lowest CTE value in the symmetrical CTE gradient is closer to the middle of the stack of multiple glass cores than a highest CTE value in the symmetrical CTE gradient (which are closer the upper and lower sides of the stack). In other examples, the different CTEs may not be symmetrical. For instance, in some examples, the top glass core 132 (e.g., the glass core closest to the dies 106, 108) has the highest CTE in the stack and the bottom glass core 136 (e.g., the glass core farthest from the dies 106, 108) has the lowest CTE with the central glass core 134 having a CTE between the other two. In other examples, the top glass core 132 (e.g., the glass core closest to the dies 106, 108) has the lowest CTE in the stack with the bottom glass core 136 having the highest CTE in the stack. Any other suitable arrangement of differing CTE values across any suitable number of stacked glass cores may additional or alternatively be implemented to achieve any suitable CTE gradient across the overall substrate core 128. In some examples, the highest CTE for a glass core is around 7 ppm/°C to 9 ppm/°C and the lowest CTE is around 3 ppm/°C to 5 ppm/°C, with one or more intervening glass core having CTEs at different incremental points between these outer limits.

In addition to implementing multiple glass cores (e.g., the glass cores 132, 134, 136) with different CTEs to reduce stress, in some examples, as already noted above, one or both of the build-up regions 130, 131 is omitted or significantly reduced in thickness (e.g., reduced in the number of metallization layers included therein). As a result, there is less stress produced on the glass cores 132, 134, 136 from the CTE mismatch between the glass and the build-up regions 130, 131.

Further, in some examples, a buffer material 140 (e.g., buffer layer, adhesive resin/material/layer) is disposed between adjacent ones of the glass cores 132, 134, 136 to hold the glass cores together. In some such examples, the buffer material 140 has a relatively low modulus of elasticity to absorb stress resulting from thermal fluctuations and the different CTEs of the different glass cores 132, 134, 136, thereby further reducing stress internal to the substrate core 128. In some examples, the buffer material 140 is an organic dielectric material (e.g., polyimide, parylene, etc.). In some examples, the buffer material 140 is an inorganic dielectric material (e.g., silicon oxide (SiOₓ), silicon nitride (SiNₓ)). In some examples, the buffer material 140 includes a carbon doped oxide (CDO). In some examples, the buffer material 140 includes the same or similar dielectric material used in the build-up regions 130, 131. In some examples, the layers of the buffer material 140 include conductive material that facilitates the redistribution of electrical paths between the glass cores 132, 134, 136. Thus, the materials between the glass cores are also referred to herein as redistribution material. Redistribution material may include one or more redistribution layers in the package substrate 110. Likewise, in such examples, the stack of glass cores 132, 134, 136 is sometimes referred to herein as a redistribution region or redistribution layer.

Although three different glass cores (e.g., the glass cores 132, 134, 136) are shown in the example substrate core 128 of FIG. 1, any other suitable number of glass cores may be implemented with corresponding CTEs to define a particular CTE gradient across the overall thickness of the substrate core 128. Thus, in some examples, only two glass cores, each with a different CTE, are employed. In other examples, more than three glass cores are employed. In some such examples, each glass core is different than every other glass core in the stack of cores. In other examples, two or more of the glass cores may have the same CTE (e.g., made from the same materials with the same composition) with at least one glass core having a different CTE than the others.

In the illustrated example of FIG. 1, each of the glass cores 132, 134, 136 is shown as having the same thickness (e.g., an approximately equal thickness). However, in some examples, the thickness of the glass cores 132, 134, 136 may differ from one another. For instance, in some examples, the middle glass core 134 is thicker than the top glass core 132 and thicker than the bottom glass core 136. In other examples, the middle glass core 134 is thinner than the top glass core 132 and thinner than the bottom glass core 136. Any suitable thickness(es) for the glass cores can be implemented to achieve a suitable CTE gradient that reduces stress to mitigate against to seware failures while also providing sufficient rigidity for the package substrate.

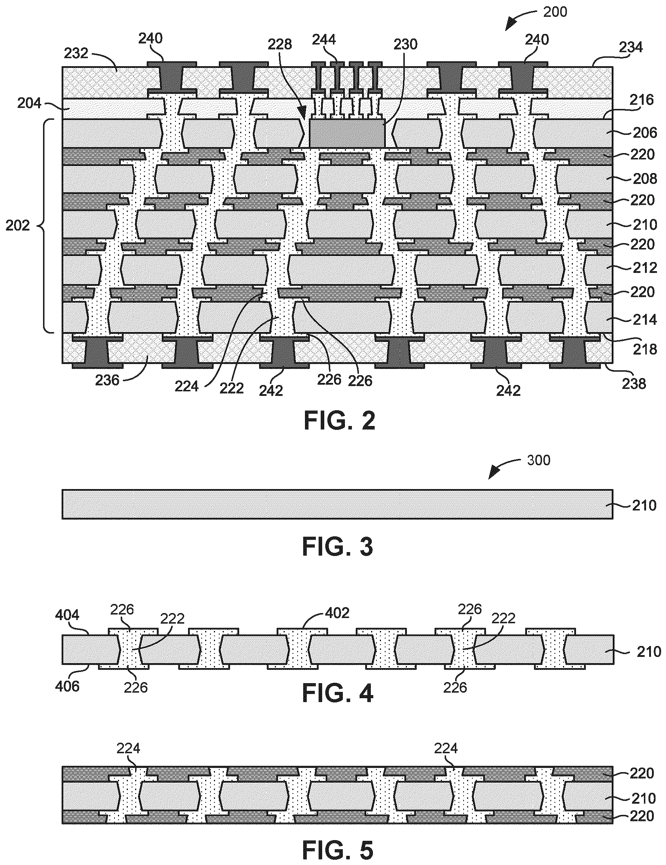

FIG. 2 illustrates an example package substrate 200 that may be used to implement the example package substrate 110 of FIG. 1. In this example, the package substrate 200 includes a substrate core 202 and an upper build-up region 204 that corresponds to the package substrate 128 and upper build-up region 130 shown in FIG. 1. Notably, in this example, there is no lower build-up region. Similar to FIG. 1, the example substrate core 202 of FIG. 2 includes a stack of multiple different (e.g., disaggregated) glass cores (e.g., multiple glass layers, multiple glass core layers, etc.). However, in this example, there are a total of five glass cores including a first glass core 206 (e.g., a top glass core, an uppermost glass core), a second glass core 208, a third glass core 210 (e.g., a middle glass core), a fourth glass core 212, and a fifth glass core 214 (e.g., a bottom glass core, a lowermost glass core). In this example, the outermost surfaces of the outermost glass cores 206, 214 define respective first and second outer surfaces 216, 218 of the overall substrate core 202. In some examples, the glass cores 206, 208, 210, 212, 214 are covered and/or coated with a liner. In such examples, the liner on the outermost glass cores 206, 214 defines the first and second outer surfaces 216, 218 of the substrate core 202.

In the illustrated example, the different glass cores 206, 208, 210, 212, 214 correspond to different ones of the glass cores 132, 134, 136 of FIG. 1. Thus, the glass cores 206, 208, 210, 212, 214 include different CTEs as described above. In this example, each of the glass cores 206, 208, 210, 212, 214 have approximately the same thickness. In some examples, different ones of the glass cores 206, 208, 210, 212, 214 can have different thicknesses. Additionally, while five glass cores are shown, in some examples, any other suitable number of glass cores (e.g., 2, 3, 4, 6, 7, 8, 10, 12, 15, etc.) may be employed. In such examples, the stack of glass cores can define any suitable CTE gradient based on differences in the CTE for each glass core in the stack. In some examples, the CTE gradient is symmetrical across the overall thickness of the substrate core 202. In other examples, the CTE gradient is not symmetrical.

In the illustrated example, the different glass cores 206, 208, 210, 212, 214 are separated by intervening layers of dielectric material 220 (e.g., adhesive material, adhesive resin) corresponding to the buffer material 140 discussed above in connection with FIG. 1. In some examples, the dielectric material 220 includes an organic epoxy-based dielectric. However, any other suitable dielectric may additionally or alternatively be used. In some examples, the dielectric material 220 has a relatively low modulus of elasticity to absorb stress resulting from thermal fluctuations and the different CTEs of the different glass cores 206, 208, 210, 212, 214.

In the illustrated example of FIG. 2, the glass cores 206, 208, 210, 212, 214 include through glass vias (TGVs) 222 that are electrically coupled by additional conductive material 224 extending through the intervening layers of the dielectric material 220. In some examples the additional conductive material 224 corresponds to metal vias that are plated within openings (e.g., holes) in the dielectric material 220. In other examples the additional conductive material 224 is dispensed into the openings or holes as a liquid metal and/or paste (e.g., copper paste and/or other suitable metal (e.g., aluminum, nickel, tin, etc.)). In some examples, the TGVs 222 are plated with the same material as used in the additional conductive material 224 (e.g., copper, aluminum, nickel, tin, etc.). In some examples, at least some of the additional conductive material 224 contains a different material than the TGVs 222. Further, as shown in the illustrated example, contact pads 226 are positioned at either end of the respective TGVs 222 (e.g., adjacent to the opposing surfaces of the corresponding glass core 206, 208, 210, 212, 214). In some examples, the contact pads 226 are integral extensions of the TGVs 222 within the glass cores 206, 208, 210, 212, 214. Thus, as shown in the illustrated examples, the contact pads 226 electrically couple the TGVs 222 and the additional conductive material 224. In this example, the outermost contact pads 226 (e.g., along the first and second outer surfaces 216, 218) define opposite ends of interconnects (e.g., portions of the interconnects 124 of FIG. 1) extending through the full thickness of the substrate core 202. In some examples, the layers of the dielectric material 220 between the glass cores 206, 208, 210, 212, 214 function as redistribution layers with metallization layers (e.g., associated with the conductive material 224 and the contact pads 226) that provide traces or routing extending between the glass cores (e.g., substantially parallel to the main planes of the glass cores) to define or redistribute electrical paths through the substrate core 202. In some examples, any suitable number of TGVs 222 can be implemented in each of the glass core 206, 208, 210, 212, 214, positioned in any suitable arrangement, and electrically coupled (via the additional conductive material 224 and/or other metal for redistribution purposes) in any suitable manner.

In this example, the first glass core 206 includes a cavity 228 containing an interconnect bridge 230 embedded therein. In this example, the interconnect bridge 230 corresponds to the interconnect bridge 126 of FIG. 1. In some examples, as shown, the interconnect bridge 230 has a thickness approximately equal to the thickness of the first glass core 206. In other examples, the thickness of the interconnect bridge 230 is less than the thickness of the first glass core 206. In other examples, the thickness of the interconnect bridge 230 is more than the thickness of the first glass core 206. For instance, in some examples, the glass cores 206, 208, 210, 212, 214 are thin relative to the interconnect bridge 230 and the interconnect bridge 230 is embedded within a cavity that extends through two or more of the glass cores 206, 208, 210, 212, 214. In some examples, regardless of the thickness of the interconnect bridge 230 relative to the thickness of the glass cores 206, 208, 210, 212, 214, the interconnect bridge 230 is positioned so that the upper surface of the interconnect bridge 230 is substantially flush with the outer surface 216 of the substrate core 202. As used herein, substantially flush mean flush within +/- 5 µm. In some examples, the thickness of the interconnect bridge 230 is greater than a thickness of the upper build-up region 204. In the past, interconnect bridges have been embedded within the build-up region of a package substrate making this possible. However, by embedding the interconnect bridge 230 within the substrate core 202, the build-up region 204 can be significantly thinner than in other known package substrates. Moreover, embedding the interconnect bridge 230 within the substrate core 202 as well as providing redistribution layer functionality within the layers of dielectric material 220 between the glass cores 206, 208, 210, 212, 214 also reduces the number of dielectric and metal layers needed within the build-up region 204. Thus, in some examples as shown in the illustrated example, there is only a single layer of dielectric material (between two metal layers). In other examples, there may still be multiple layers of the dielectric material between multiple layers of metal.

As shown in the illustrated example, a first solder resist layer 232 is added onto the build-up region 204. In this example, the first solder resist layer 232 defines a first outer surface 234 (e.g., the uppermost surface) of the package substrate 200. That is, the solder resist layer 232 defines the die mounting surface 122 of the package substrate 110 of FIG. 1. In some examples, the upper build-up region 204 can be omitted entirely such that the uppermost glass core 206 is adjacent to the first solder resist layer 232 similar to what is shown on the bottom side of the package substrate 200. That is, in this example, a second solder resist layer 236 is provided adjacent the fifth glass core 214 to define a second outer surface 238 of the package substrate 200 (e.g., corresponding to the package mounting surface 105 of the package substrate 110 of FIG. 1).

In some examples, first and second contacts 240, 242 are provided along the first and second solder resist layers 232, 236 and are electrically coupled to the TGVs 222. In this example, the first contacts 240 along the first solder resist layer 232 correspond to the contacts 120 of FIG. 1 and the second contacts 242 along the second solder resist layer 236 correspond to the contacts 104 of FIG. 1. Thus, the first and second contacts 240, 242 in FIG. 2 represent opposite ends of corresponding ones of the internal interconnects 124 extending through the package substrate as discussed above in FIG. 1. Further, in this example, third contacts 244 are provided along the first solder resist layer 232 and are electrically coupled to the interconnect bridge 230. Thus, in this example, the third contacts 244 correspond to the location of the bridge bumps 118 of FIG. 1.

FIGS. 3-10 illustrate different stages in an example fabrication process to manufacture the example package substrate 200 of FIG. 2. FIG. 3 represents a glass panel 300 corresponding to the initial state of any one of the glass cores 206, 208, 210, 212, 214. For purposes of explanation, the glass panel 300 is shown and described as corresponding to the third glass core 210 (e.g., the middle glass core in the substrate core 202 of FIG. 2). In some examples, the glass panel 300 is fabricated to a thickness corresponding to the final thickness of the third glass core 210. However, in some examples, the glass panel 300 is initially slightly larger than the final thickness of the third glass core 210 to enable some amount of the glass to be removed during subsequent polishing or planarization processes as discussed further below.

FIG. 4 represents the stage of fabrication following the providing the third glass core 210 of FIG. 3 with the TGVs 222. In some examples, the TGVs 222 are added by first providing corresponding openings (e.g., holes) within the glass core through a laser induced deep etching (LIDE) process. Once the openings are provided, a metal 402 (e.g., copper, aluminum, nickel, tin, etc.) is plated within the openings to define the TGVs 222. In this example, the TGVs 222 have a cross-sectional profile generally corresponding to an hourglass shape with the width (e.g., diameter) of the TGVs 222 being narrower near a midpoint of the openings between opposing first and second surfaces 404, 406 of the glass core 210. In other examples, one or more of the TGVs 222 may have a different cross-sectional shape. For instance, in some examples, one or more of the TGVs 222 may have a generally conical or tapered shape with the width (e.g., diameter) being smallest at one of the two surfaces 404, 406 of the glass core 210 and the width (e.g., diameter) being largest at the opposite surface 404, 406. In other examples, the width (e.g., diameter) of one or more of the TGVs 222 is approximately consistent along a full length of the TGVs 222 between the opposing surfaces 506, 508 of the glass core 210.

FIG. 4 also represents the stage of fabrication after adding the contact pads 226 to both ends of the TGVs 222 (e.g., adjacent each of the outer surfaces 404, 406 of the glass core 210). In some examples, the contact pads 226 are composed of the same metal 402 as the TGVs and added during the same process. That is, in some examples, the metal 402 is deposited via an electroplating process and the process continues to provide the contact pads 226. In some such examples, excess portions of the metal 402 may be removed (e.g., via a selective etch using photolithography) to define the final shape of the contact pads 226. In some examples, the contact pads 226 are provided (e.g., plated) in a separate process to the TGVs 222. In some examples, the contact pads 226 are omitted. In some examples, the metal 402 is plated after the deposition of a metal seed layer on the surface of the glass core 210 (e.g., on inner sidewalls of the openings and/or on the outer surfaces 404, 406). In other examples, the TGVs 222 are plated from the bottom up without a seed layer. In some such examples, the glass core 210 of FIG. 4 is first attached to a conductive carrier to provide metal at the bottom of the openings where the TGVs 222 are located to enable initiation of the plating process. The stage of fabrication represented in FIG. 4 is also after a polishing process (e.g., a CMP process) to flatten or even out the metal 402 on the outer surfaces 404, 406 of the glass core 210 (e.g., to flatten the contact pads 226).

FIG. 5 represents the stage of fabrication following the deposition of the dielectric material 220 (e.g., via lamination) to both sides of the third glass core 2410 of FIG. 4. Further, FIG. 5 represents the stage of fabrication following the adding of the additional conductive material 224 (e.g., conductive vias) into the dielectric material 220. In some examples, the process to add the additional conductive material 224 includes drilling (e.g., laser drilling) holes through the dielectric material to expose the contact pads 226 thereunder and then depositing (e.g., plating) more of the metal 402 into the holes. In other examples, the additional conductive material 224 is dispensed in such holes as a liquid metal and/or paste that is then permitted to cure or harden. In some examples, excess amounts of the additional conductive material 224 (e.g., that extends beyond and/or above the outer surface of the dielectric material 220) is removed through a polishing process (e.g., a CMP process) to make the layers of the dielectric material 220 and the additional conductive material 224 flush with each other.

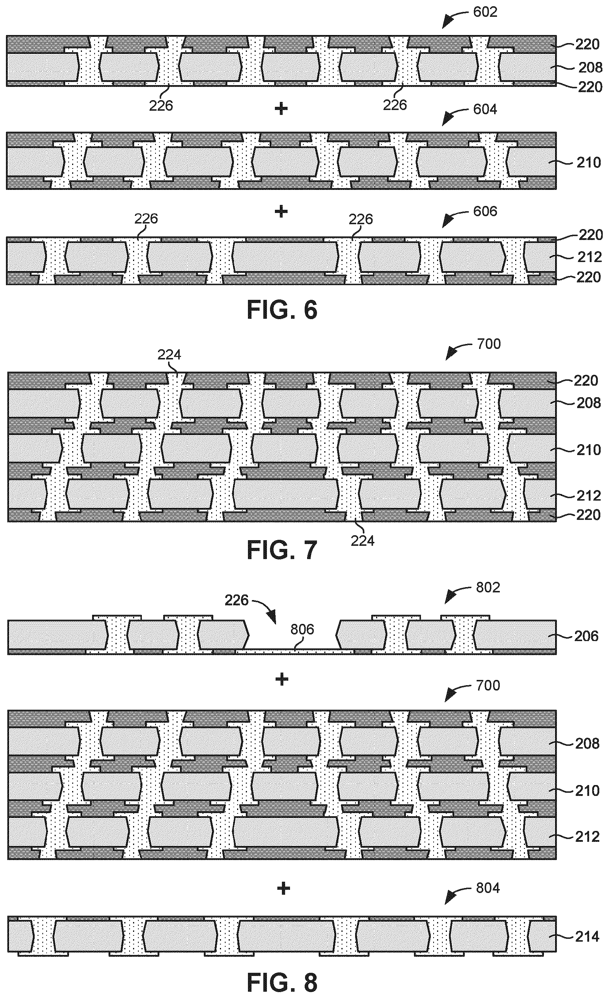

FIG. 6 represents the stage of fabrication when each of the glass cores except for the outermost (e.g., top and bottom) glass cores (e.g., the three internal glass cores 208, 210, 212 of the substrate core 202 of FIG. 2) are assembled or stacked together by combining or joining respective glass core assemblies 602, 604, 606. In this example, each of the glass core assemblies 602, 604, 606 of FIG. 6 are the result of processing the corresponding second, third, and fourth glass cores 208, 210, 212 through the stages of fabrication represented in FIGS. 3-10. That is, in this example, each of the glass core assemblies 602, 604, 606 of FIG. 6 are the result of processing the corresponding glass cores 208, 210, 212 through the stages of fabrication represented in FIGS. 3-5. Thus, the third glass core 210 processed to the point represented in FIG. 5, as described above, corresponds to the second glass core assembly 604 shown in FIG. 6.

As shown in FIG. 6, the first glass core assembly 602 is similar to the second glass core assembly 604 except for a different glass core (e.g., the second glass core 208 instead of the second glass core 210) with a different CTE. Further, as shown in FIG. 6, the dielectric material 220 added to the first glass core assembly 602 is thinner on the bottom side (e.g., the side facing the second glass core assembly 604). In this example, the dielectric material 220 material is thinner on the bottom side because that side does not include the additional conductive material 224. That is, in this example, only the contact pads 226 are provided on the bottom side of the first glass core assembly 602. Another difference between the first glass core assembly 602 and the second glass core assembly 604 is the position of the TGVs 222 and the associated contact pads 226. In the illustrated example of FIG. 6, the third glass core assembly 606 is fabricated similarly to the first glass core assembly 602 except for the different glass core 212 (with different CTE) and with a thinner layer of dielectric material 220 on the upper side (e.g., the side facing the second glass core assembly 604).

In some examples, once the different glass core assemblies 602, 604, 606 are brought together (as represented in FIG. 6), the stack is pressed together (e.g., subject to compression). In some examples, the dielectric material 220 is an adhesive resin that undergoes a curing process (e.g., at an elevated temperature) during this compression process to firmly join the assemblies 602, 604, 606. The final result of combining or joining the different glass core assemblies 602, 604, 606 produces the internal glass core stack-up assembly 700 shown in FIG. 7. Although the dielectric material 220 is shown and described as being applied to both interfacing surfaces of the glass cores 208, 210, 212 before assembling, in some examples, the dielectric material 220 is only added to one of the two interfacing surfaces. In some examples, the second and third glass core assemblies 604, 606 are combined with the first glass core assembly 602 prior to adding the additional conductive material 224 onto the second and third glass core assemblies 604, 606. That is, in some examples, the outermost layers of the dielectric material 220 shown in FIG. 7 and the associated additional conductive material 224 can be added after the three glass cores 208, 210, 212 are joined together.

FIG. 8 represents the stage of fabrication following the processing of additional glass panels associated with the first and fifth glass cores 206, 214 through a similar process detailed above in connection with FIGS. 3-5 to produce additional glass core assemblies 802, 804. Further, FIG. represents the combining or joining of these glass core assemblies 802, 804 with the internal glass core stack-up assembly 700 of FIG. 7. As shown in FIG. 8, the dielectric material 220 is only added to one side of each of the additional glass core assemblies 802, 804 (e.g., the side facing towards the internal glass core stack-up assembly 700).

In this example, the first glass core 206 of the uppermost glass core assembly 802 in FIG. 8 is fabricated with a relatively large cavity (e.g., the cavity 228) that is closed off at the bottom end by a relatively large conductive pad 806. In some examples, the cavity 228 is fabricated during the same LIDE process used to fabricate the openings for the TGVs 222. In other examples, the cavity 228 is fabricated in a separate process.

In some examples, once the different glass core assemblies 700, 802, 804 are brought together (as represented in FIG. 7), the stack is pressed together (e.g., subject to compression) and the dielectric material 220 (e.g., an adhesive resin) undergoes a curing process (e.g., at an elevated temperature) to firmly join the assemblies 700, 802, 804. The final result of combining or joining the different glass core assemblies 700, 802, 804 produces the complete package substrate 200 shown in FIG. 2.

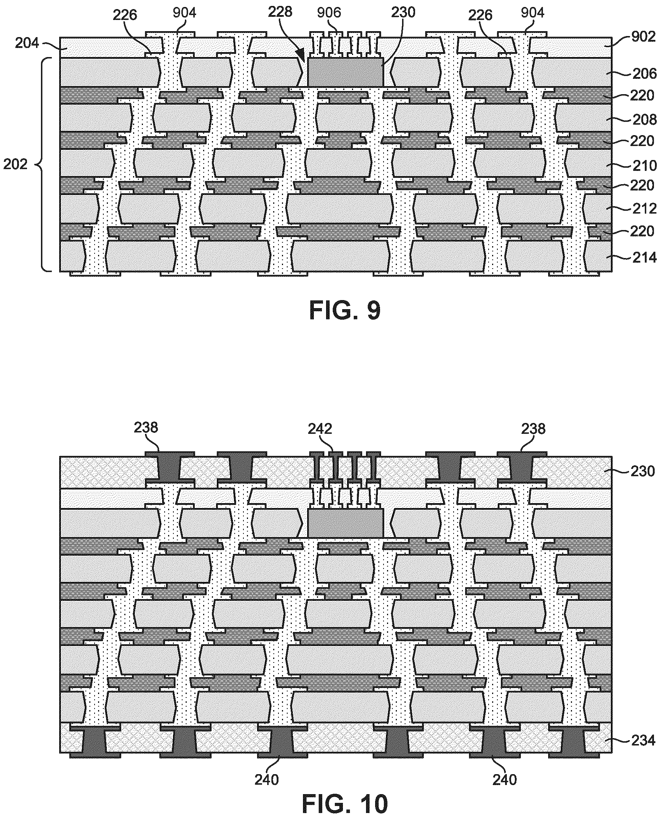

FIG. 9 represents the stage of fabrication following the embedding of the interconnect bridge 230 within substrate core 202 of the stack of glass cores 206, 208, 210, 212, 214 joined together as shown in FIG. 8. More particularly, as shown in the illustrated example, the interconnect bridge 230 is placed within the cavity 228 of the first glass core 206. In some examples, the interconnect bridge 230 is placed within the first glass core 206 before the first glass core 206 is combined with the other glass cores. That is, in some examples, the uppermost glass core assembly 802 of FIG. 8 may already include the interconnect bridge 230 embedded therein.

The stage of fabrication represented in FIG. 9 also follows the addition of the build-up region 204 over first glass core 206 and the interconnect bridge 230. In this example, the build-up region 204 includes a single dielectric layer 902 separating the contact pads 226 associated with the TGVs 222 in the first glass core 206 from additional contact pads 904 on the outer surface of the assembly. In some examples, the build-up region 204 includes two or more dielectric layers with intervening metal layers. In this example, additional contacts 906 are added to extend through the build-up region 204 and to electrically couple with the interconnect bridge 230.

In some examples, the dielectric layer 902 is added through a lamination process. Thereafter, the contact pads 904 and additional contacts 906 are added by drilling holes through the dielectric layer 902 and then filling the holes with metal and adding additional metal overtop of the outer surface of the dielectric layer 902. In some examples, the lamination of the dielectric layer 902 results in gaps surrounding the interconnect bridge 230 within the cavity 228 being filled. That is, in some examples, the same material used in the dielectric layer 902 laterally encloses (e.g., at least partially surrounds) the interconnect bridge 230. In some examples, a separate dielectric material is added to fill the cavity 228 around the interconnect bridge 230 prior to the addition of the dielectric layer 902 across the top of the interconnect bridge 230. In some such examples, the dielectric material in the cavity 228 is the same as the material used for the dielectric layer 902 above the interconnect bridge 230. In other examples, different dielectric materials can be used in the cavity 228 and above the interconnect bridge 230. Further, in some examples, one or both of the dielectric materials surrounding the interconnect bridge 230 within the cavity and overtop of the interconnect bridge he material in the dielectric layer 902 may be the same as the dielectric material 220 between the glass cores 206, 208, 210, 212, 214. In other examples, the dielectric material 220 between the glass cores 206, 208, 210, 212, 214 is different than the dielectric materials in contact with the lateral sides and top of the interconnect bridge 230.

FIG. 10 represents the stage of fabrication following the addition of the solder resist layers 232, 236 and the associated contacts 240, 242, 244 for the first level interconnects (along the first outer surface 234) and the second level interconnects (along the second surface 238). FIG. 10 represents the completion of the fabrication process. Thus, as shown, FIG. 10 is the same as the package substrate 200 shown in FIG. 2.

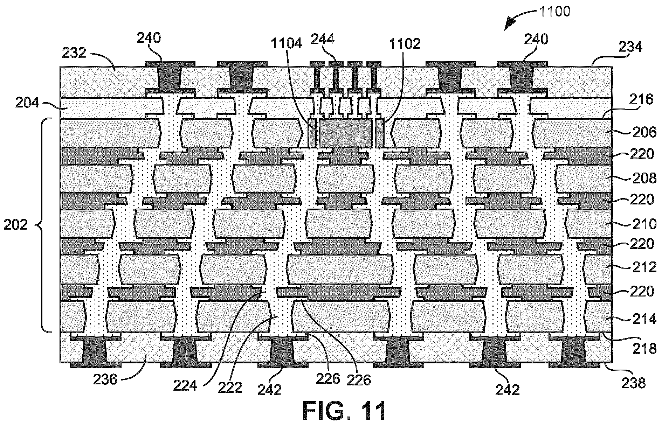

FIG. 11 illustrates another example package substrate 1100 that may be used to implement the example package substrate 110 of FIG. 1. The example package substrate 1100 of FIG. 11 is substantially the same as the example package substrate 200 of FIG. 2 except as noted below or otherwise made clear from the context. Accordingly, the features shown in FIG. 11 that are the same or similar to corresponding features in FIG. 2 (and associated FIGS. 3-10) are identified by the same reference numbers. Further, the description of such features described above in connection with FIG. 2 (and associated FIGS. 3-10) applies similarly with respect to the corresponding features in FIG. 11. The difference between the example package substrate 1100 of FIG. 11 and the example package substrate 1200 of FIG. 2 is the inclusion of a different example interconnect bridge 1102. More particularly, as shown in FIG. 11, the example interconnect bridge 1102 includes through-silicon vias (TSVs) 1104 that extend through the bridge and are electrically coupled to underlying TGVs 222 within the glass cores 206, 208, 210, 212, 214 of the substrate core 202. In some examples, the TSVs 222 can be connected to the power source of an associated IC package (e.g., the IC package 100 of FIG. 1) to improve power delivery relative to the interconnect bridge 230 shown in FIG. 2.

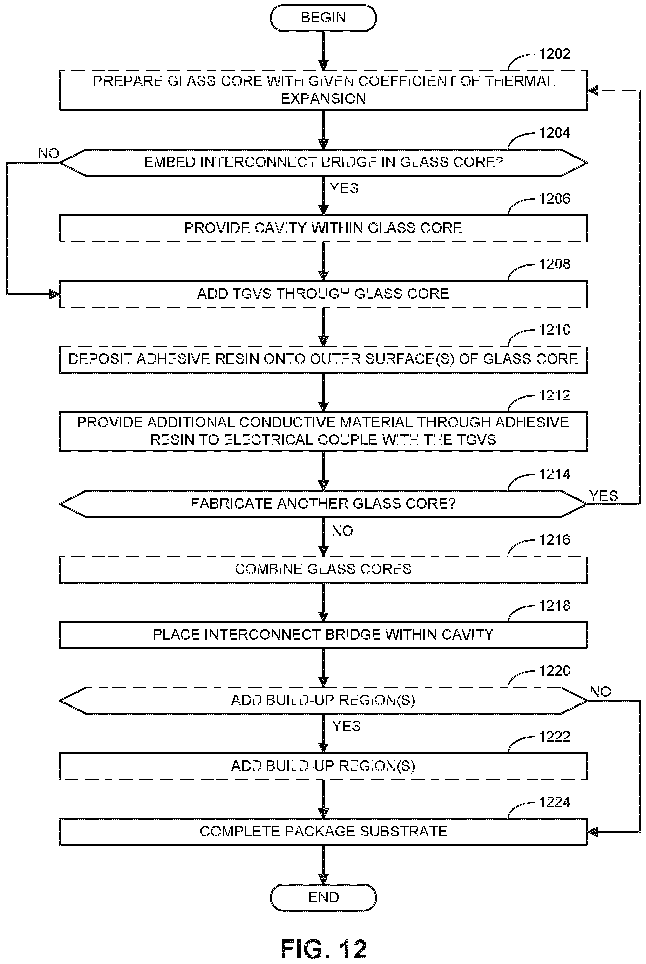

FIG. 12 is a flowchart representative of an example method of manufacturing any one of the example package substrates 110, 200, 1100 of FIGS. 1, 2, and 11. In some examples, some or all of the operations outlined in the example method of FIG. 12 are performed automatically by fabrication equipment that is programmed to perform the operations. Although the example method of manufacture is described with reference to the flowchart illustrated in FIG. 12, many other methods may alternatively be used. For example, the order of execution of the blocks may be changed, and/or some of the blocks described may be combined, divided, re-arranged, omitted, eliminated, and/or implemented in any other way. Further, in some examples, additional processing operations can be performed before, between, and/or after any of the blocks represented in the illustrated example.

The example method of FIG. 12 begins at block 1202 by preparing a glass core (e.g., anyone of the example glass cores 206, 208, 210, 212, 214) with a given coefficient of thermal expansion (CTE) (e.g., as discussed in connection with FIG. 3). In some examples, the composition of materials used in the glass core is selected to achieve the CTE intended for a particular layer of glass within an overall substrate core (e.g., the substrate core 202) that includes multiple glass cores stacked together.

At block 1204, the example method involves determining whether to embed an interconnect bridge in the glass core. If so, the method advances to block 1206 where a cavity within the glass core is provided (e.g., as discussed above in connection with FIG. 8). Thereafter, the method advances to block 1208. If no interconnect bridge is to be embedded in the glass core (as determined at block 1204), the method advances directly to block 1208.

At block 1208, the example method involves adding TGVs (e.g., the TGVs 222) through the glass core (e.g., as discussed in connection with FIG. 4). In some examples, adding the TGVs 222 includes adding the contact pads 226 at the ends of the TGVs 222.

At block 1210, the example method involves depositing an adhesive resin (e.g., the dielectric material 220) onto one or both of the outer surfaces of the glass core (e.g., as described in connection with FIGS. 5 and 6). At block 1212, the example method involves providing additional conductive material (e.g., the conductive material 224) through the adhesive resin to electrical couple with the TGVs 22 (e.g., as also discussed in connection with FIGS. 5 and 6). In some examples, the additional conductive material is a liquid metal or paste dispensed within holes drilled through the dielectric resin. In other examples, the additional conductive material is plated within such holes.

At block 1214, the example method involves determining whether to fabricate another glass core. If so, the method returns to block 1202 to repeat the process for a different glass core. In some examples, the different glass core can be constructed with a different CTE. In some examples, the next glass core is fabricated independent of the previously fabricated glass core. Accordingly, in some examples, separate iterations through the example process can be performed in parallel rather than sequentially.

Once there are no further glass cores to fabricate, the example method advances to block 1216 that involves combining the glass cores. In some examples, the adhesive resin (added at block 1210) is used to attach the different glass cores together (e.g., as discussed in connection with FIGS. 6 and 8). In some examples, two or more glass cores are combined (at block 1216) before determining to fabricate additional glass cores (determined at block 1214). In some examples, at least some of the conductive material added at block 1212 can be added after the glass cores are combined at block 1216.

At block 1218, the example method involves placing an interconnect within the cavity (e.g., the cavity made in at least one glass core at block 1206). At block 1220, the example method involves determining whether to add build-up regions (e.g., the build-up regions 130, 131, 204 of FIGS. 1 and/or 2). If so, the method advances to block 1222 where the build-up region(s) are added (e.g., as discussed in connect with FIG. 9). In some examples, the build-up regions are added by depositing (e.g., laminating) one or more layers of dielectric material layer between layers of metal. In some examples, the dielectric layer is an organic epoxy-based dielectric that is laminated onto the glass core. Thereafter, the method advances to block 1224. Returning to block 1220, if no build-up region(s) are to be added, the method advances directly to block 1224.

At block 1224, the example method involves completing the package substrate. In some examples, this includes adding solder resist layers (e.g., the solder resist layers 232, 236 discussed in connection with FIG. 10). Additionally or alternatively, in some examples, completing the package substrate includes adding contacts on the external surfaces of the package substrate (e.g., the contacts 240, 242, 244). Thereafter, the example method of FIG. 12 ends.

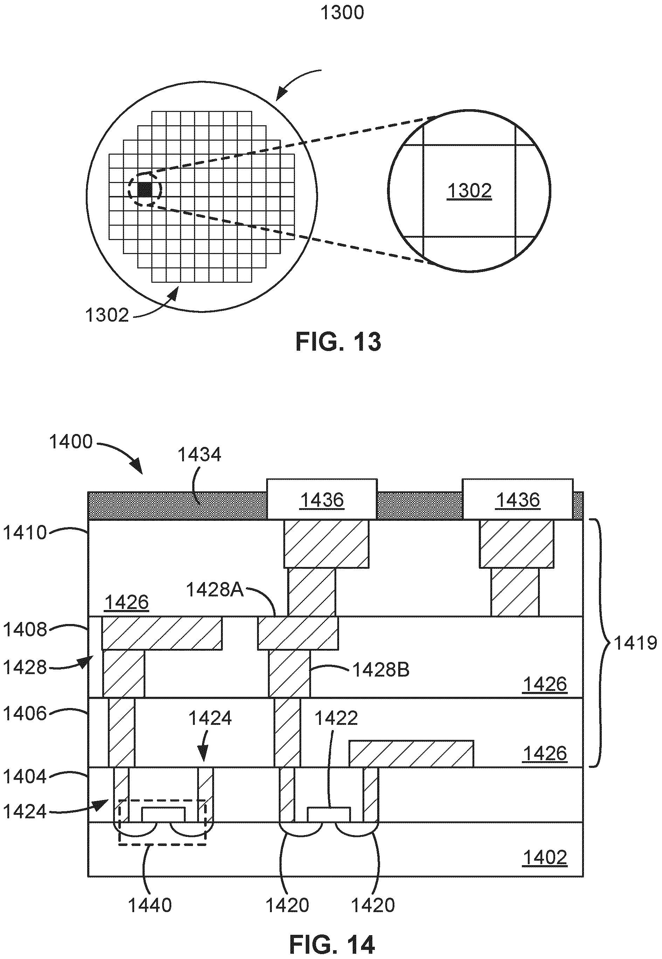

The example IC package 100 disclosed herein (including any one of the example package substrates 110, 200, 1100) may be included in any suitable electronic component. FIGS. 13-16 illustrate various examples of apparatus that may include or be included in the IC package 100 disclosed herein.

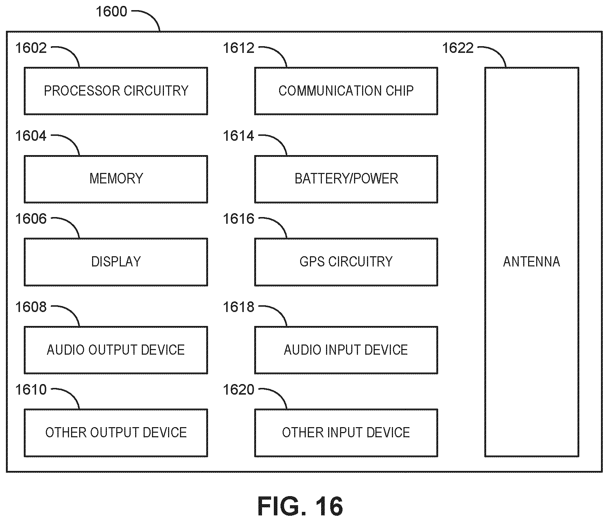

FIG. 19 is a top view of a wafer 1900 and dies 1902 that may be included in the IC package 100 of FIG. 1 (e.g., as any suitable ones of the dies 106, 108). The wafer 1300 includes semiconductor material and one or more dies 1302 having circuitry. Each of the dies 1302 may be a repeating unit of a semiconductor product. After the fabrication of the semiconductor product is complete, the wafer 1300 may undergo a singulation process in which the dies 1302 are separated from one another to provide discrete "chips." The die 1302 includes one or more transistors (e.g., some of the transistors 1440 of FIG. 14, discussed below), supporting circuitry to route electrical signals to the transistors, passive components (e.g., traces, resistors, capacitors, inductors, and/or other circuitry), and/or any other components. In some examples, the die 1302 may include and/or implement a memory device (e.g., a random access memory (RAM) device, such as a static RAM (SRAM) device, a magnetic RAM (MRAM) device, a resistive RAM (RRAM) device, a conductive-bridging RAM (CBRAM) device, etc.), a logic device (e.g., an AND, OR, NAND, or NOR gate), or any other suitable circuitry or electronics. Multiple ones of these devices may be combined on a single die 1302. For example, a memory array of multiple memory circuits may be formed on a same die 1302 as programmable circuitry (e.g., the processor circuitry 1602 of FIG. 16) and/or other logic circuitry. Such memory may store information for use by the programmable circuitry. The example IC package 100 disclosed herein may be manufactured using a die-to-wafer assembly technique in which some dies are attached to a wafer 1300 that includes others of the dies, and the wafer 1300 is subsequently singulated.

FIG. 20 is a cross-sectional side view of an IC device 2000 that may be included in the example IC package 100 (e.g., in any one of the dies 106, 108). One or more of the IC devices 1400 may be included in one or more dies 1302 (FIG. 13). The IC device 1400 may be formed on a die substrate 1402 (e.g., the wafer 1300 of FIG. 13) and may be included in a die (e.g., the die 1302 of FIG. 13). The die substrate 1402 may be a semiconductor substrate including semiconductor materials including, for example, n-type or p-type materials systems (or a combination of both). The die substrate 1402 may include, for example, a crystalline substrate formed using a bulk silicon or a silicon-on-insulator (SOI) substructure. In some examples, the die substrate 1402 may be formed using alternative materials, which may or may not be combined with silicon, that include but are not limited to germanium, indium antimonide, lead telluride, indium arsenide, indium phosphide, gallium arsenide, or gallium antimonide. Further materials classified as group II-VI, III-V, or IV may also be used to form the die substrate 1402. Although a few examples of materials from which the die substrate 1402 may be formed are described here, any material that may serve as a foundation for an IC device 1400 may be used. The die substrate 1402 may be part of a singulated die (e.g., the dies 1302 of FIG. 13) or a wafer (e.g., the wafer 1300 of FIG. 13).

The IC device 1400 may include one or more device layers 1404 disposed on and/or above the die substrate 1402. The device layer 1404 may include features of one or more transistors 1440 (e.g., metal oxide semiconductor field-effect transistors (MOSFETs)) formed on the die substrate 1402. The device layer 1404 may include, for example, one or more source and/or drain (S/D) regions 1420, a gate 1422 to control current flow between the S/D regions 1420, and one or more S/D contacts 1424 to route electrical signals to/from the S/D regions 1420. The transistors 1440 may include additional features not depicted for the sake of clarity, such as device isolation regions, gate contacts, and the like. The transistors 1440 are not limited to the type and configuration depicted in FIG. 14 and may include a wide variety of other types and/or configurations such as, for example, planar transistors, non-planar transistors, or a combination of both. Non-planar transistors may include FinFET transistors, such as double-gate transistors or tri-gate transistors, and wrap-around or all-around gate transistors, such as nanoribbon and nanowire transistors.

Each transistor 1440 may include a gate 1422 including a gate dielectric and a gate electrode. The gate dielectric may include one layer or a stack of layers. The one or more layers may include silicon oxide, silicon dioxide, silicon carbide, and/or a high-k dielectric material. The high-k dielectric material may include elements such as hafnium, silicon, oxygen, titanium, tantalum, lanthanum, aluminum, zirconium, barium, strontium, yttrium, lead, scandium, niobium, and/or zinc. Examples of high-k materials that may be used in the gate dielectric include, but are not limited to, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and/or lead zinc niobate. In some examples, an annealing process may be carried out on the gate dielectric to improve its quality when a high-k material is used.

The gate electrode may be formed on the gate dielectric and may include at least one p-type work function metal or n-type work function metal, depending on whether the transistor 1440 is to be a p-type metal oxide semiconductor (PMOS) or an n-type metal oxide semiconductor (NMOS) transistor. In some implementations, the gate electrode may include a stack of two or more metal layers, where one or more metal layers are work function metal layers and at least one metal layer is a fill metal layer. Further metal layers may be included, such as a barrier layer. For a PMOS transistor, metals that may be used for the gate electrode include, but are not limited to, ruthenium, palladium, platinum, cobalt, nickel, conductive metal oxides (e.g., ruthenium oxide), and/or any of the metals discussed below with reference to an NMOS transistor (e.g., for work function tuning). For an NMOS transistor, metals that may be used for the gate electrode include, but are not limited to, hafnium, zirconium, titanium, tantalum, aluminum, alloys of these metals, carbides of these metals (e.g., hafnium carbide, zirconium carbide, titanium carbide, tantalum carbide, and/or aluminum carbide), and/or any of the metals discussed above with reference to a PMOS transistor (e.g., for work function tuning).

In some examples, when viewed as a cross-section of the transistor 1440 along the source-channel-drain direction, the gate electrode may include a U-shaped structure that includes a bottom portion substantially parallel to the surface of the die substrate 1402 and two sidewall portions that are substantially perpendicular to the top surface of the die substrate 1402. In other examples, at least one of the metal layers that form the gate electrode may be a planar layer that is substantially parallel to the top surface of the die substrate 1402 and does not include sidewall portions substantially perpendicular to the top surface of the die substrate 1402. In other examples, the gate electrode may include a combination of U-shaped structures and/or planar, non-U-shaped structures. For example, the gate electrode may include one or more U-shaped metal layers formed atop one or more planar, non-U-shaped layers.

In some examples, a pair of sidewall spacers may be formed on opposing sides of the gate stack to bracket the gate stack. The sidewall spacers may be formed from materials such as silicon nitride, silicon oxide, silicon carbide, silicon nitride doped with carbon, and/or silicon oxynitride. Processes for forming sidewall spacers are well known in the art and generally include deposition and etching process operations. In some examples, a plurality of spacer pairs may be used; for instance, two pairs, three pairs, or four pairs of sidewall spacers may be formed on opposing sides of the gate stack.

The S/D regions 1420 may be formed within the die substrate 1402 adjacent to the gate 1422 of corresponding transistor(s) 1440. The S/D regions 1420 may be formed using an implantation/diffusion process or an etching/deposition process, for example. In the former process, dopants such as boron, aluminum, antimony, phosphorous, or arsenic may be ion-implanted into the die substrate 1402 to form the S/D regions 1420. An annealing process that activates the dopants and causes them to diffuse farther into the die substrate 1402 may follow the ion-implantation process. In the latter process, the die substrate 1402 may first be etched to form recesses at the locations of the S/D regions 1420. An epitaxial deposition process may then be carried out to fill the recesses with material that is used to fabricate the S/D regions 1420. In some implementations, the S/D regions 1420 may be fabricated using a silicon alloy such as silicon germanium or silicon carbide. In some examples, the epitaxially deposited silicon alloy may be doped in situ with dopants such as boron, arsenic, or phosphorous. In some examples, the S/D regions 1420 may be formed using one or more alternate semiconductor materials such as germanium or a group III-V material or alloy. In further examples, one or more layers of metal and/or metal alloys may be used to form the S/D regions 1420.

Electrical signals, such as power and/or input/output (I/O) signals, may be routed to and/or from the devices (e.g., transistors 1440) of the device layer 1404 through one or more interconnect layers disposed on the device layer 1404 (illustrated in FIG. 14 as interconnect layers 1406-2010). For example, electrically conductive features of the device layer 1404 (e.g., the gate 1422 and the S/D contacts 1424) may be electrically coupled with the interconnect structures 1428 of the interconnect layers 1406-2010. The one or more interconnect layers 1406-2010 may form a metallization stack (also referred to as an "ILD stack") 1419 of the IC device 1400.

The interconnect structures 1428 may be arranged within the interconnect layers 1406-2010 to route electrical signals according to a wide variety of designs (in particular, the arrangement is not limited to the particular configuration of interconnect structures 1428 depicted in FIG. 14). Although a particular number of interconnect layers 1406-2010 is depicted in FIG. 14, examples of the present disclosure include IC devices having more or fewer interconnect layers than depicted.

In some examples, the interconnect structures 1428 may include lines 1428a and/or vias 1428b filled with an electrically conductive material such as a metal. The lines 1428a may be arranged to route electrical signals in a direction of a plane that is substantially parallel with a surface of the die substrate 1402 upon which the device layer 1404 is formed. For example, the lines 1428a may route electrical signals in a direction in and/or out of the page from the perspective of FIG. 14. The vias 1428b may be arranged to route electrical signals in a direction of a plane that is substantially perpendicular to the surface of the die substrate 1402 upon which the device layer 1404 is formed. In some examples, the vias 1428b may electrically couple lines 1428a of different interconnect layers 1406-2010 together.

The interconnect layers 1406-2010 may include a dielectric material 1426 disposed between the interconnect structures 1428, as shown in FIG. 14. In some examples, the dielectric material 1426 disposed between the interconnect structures 1428 in different ones of the interconnect layers 1406-2010 may have different compositions; in other examples, the composition of the dielectric material 1426 between different interconnect layers 1406-2010 may be the same.

A first interconnect layer 1406 (referred to as Metal 1 or "M1") may be formed directly on the device layer 1404. In some examples, the first interconnect layer 1406 may include lines 1428a and/or vias 1428b, as shown. The lines 1428a of the first interconnect layer 1406 may be coupled with contacts (e.g., the S/D contacts 1424) of the device layer 1404.

A second interconnect layer 1408 (referred to as Metal 2 or "M2") may be formed directly on the first interconnect layer 1406. In some examples, the second interconnect layer 1408 may include vias 1428b to couple the lines 1428a of the second interconnect layer 1408 with the lines 1428a of the first interconnect layer 1406. Although the lines 1428a and the vias 1428b are structurally delineated with a line within each interconnect layer (e.g., within the second interconnect layer 1408) for the sake of clarity, the lines 1428a and the vias 1428b may be structurally and/or materially contiguous (e.g., simultaneously filled during a dual-damascene process) in some examples.

A third interconnect layer 1410 (referred to as Metal 3 or "M3") (and additional interconnect layers, as desired) may be formed in succession on the second interconnect layer 1408 according to similar techniques and/or configurations described in connection with the second interconnect layer 1408 or the first interconnect layer 1406. In some examples, the interconnect layers that are "higher up" in the metallization stack 1419 in the IC device 1400 (i.e., further away from the device layer 1404) may be thicker.

The IC device 1400 may include a solder resist material 1434 (e.g., polyimide or similar material) and one or more conductive contacts 1436 formed on the interconnect layers 1406-2010. In FIG. 14, the conductive contacts 1436 are illustrated as taking the form of bond pads. The conductive contacts 1436 may be electrically coupled with the interconnect structures 1428 and configured to route the electrical signals of the transistor(s) 1440 to other external devices. For example, solder bonds may be formed on the one or more conductive contacts 1436 to mechanically and/or electrically couple a chip including the IC device 1400 with another component (e.g., a circuit board). The IC device 1400 may include additional or alternate structures to route the electrical signals from the interconnect layers 1406-2010; for example, the conductive contacts 1436 may include other analogous features (e.g., posts) that route the electrical signals to external components.

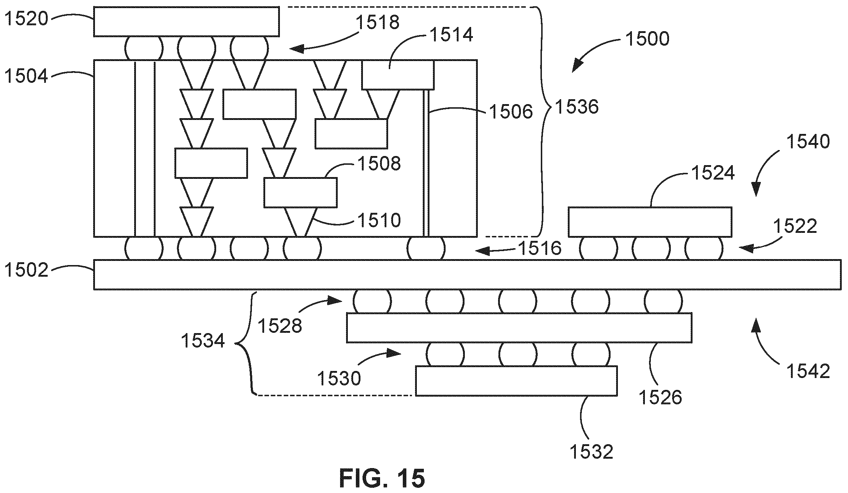

FIG. 15 is a cross-sectional side view of an IC device assembly 1500 that may include the IC package 100 disclosed herein. In some examples, the IC device assembly corresponds to the IC package 100. The IC device assembly 1500 includes a number of components disposed on a circuit board 1502 (which may be, for example, a motherboard). The IC device assembly 1500 includes components disposed on a first face 1540 of the circuit board 1502 and an opposing second face 1542 of the circuit board 1502; generally, components may be disposed on one or both faces 1540 and 1542. Any of the IC packages discussed below with reference to the IC device assembly 2200 may take the form of the example IC package 100 of FIG. 1.

In some examples, the circuit board 1502 may be a printed circuit board (PCB) including multiple metal layers separated from one another by layers of dielectric material and interconnected by electrically conductive vias. Any one or more of the metal layers may be formed in a desired circuit pattern to route electrical signals (optionally in conjunction with other metal layers) between the components coupled to the circuit board 1502. In other examples, the circuit board 1502 may be a non-PCB substrate.

The IC device assembly 1500 illustrated in FIG. 15 includes a package-on-interposer structure 1536 coupled to the first face 1540 of the circuit board 1502 by coupling components 1516. The coupling components 1516 may electrically and mechanically couple the package-on-interposer structure 1536 to the circuit board 1502, and may include solder balls (as shown in FIG. 15), male and female portions of a socket, an adhesive, an underfill material, and/or any other suitable electrical and/or mechanical coupling structure.

The package-on-interposer structure 1536 may include an IC package 1520 coupled to an interposer 1504 by coupling components 1518. The coupling components 1518 may take any suitable form for the application, such as the forms discussed above with reference to the coupling components 1516. Although a single IC package 1520 is shown in FIG. 15, multiple IC packages may be coupled to the interposer 1504; indeed, additional interposers may be coupled to the interposer 1504. The interposer 1504 may provide an intervening substrate used to bridge the circuit board 1502 and the IC package 1520. The IC package 1520 may be or include, for example, a die (the die 1302 of FIG. 13), an IC device (e.g., the IC device 1400 of FIG. 14), or any other suitable component. Generally, the interposer 1504 may spread a connection to a wider pitch or reroute a connection to a different connection. For example, the interposer 1504 may couple the IC package 1520 (e.g., a die) to a set of BGA conductive contacts of the coupling components 1516 for coupling to the circuit board 1502. In the example illustrated in FIG. 15, the IC package 1520 and the circuit board 1502 are attached to opposing sides of the interposer 1504; in other examples, the IC package 1520 and the circuit board 1502 may be attached to a same side of the interposer 1504. In some examples, three or more components may be interconnected by way of the interposer 1504.

In some examples, the interposer 1504 may be formed as a PCB, including multiple metal layers separated from one another by layers of dielectric material and interconnected by electrically conductive vias. In some examples, the interposer 1504 may be formed of an epoxy resin, a fiberglass-reinforced epoxy resin, an epoxy resin with inorganic fillers, a ceramic material, or a polymer material such as polyimide. In some examples, the interposer 1504 may be formed of alternate rigid or flexible materials that may include the same materials described above for use in a semiconductor substrate, such as silicon, germanium, and other group III-V and group IV materials. The interposer 1504 may include metal interconnects 1508 and vias 1510, including but not limited to through-silicon vias (TSVs) 1506. The interposer 1504 may further include embedded devices 1514, including both passive and active devices. Such devices may include, but are not limited to, capacitors, decoupling capacitors, resistors, inductors, fuses, diodes, transformers, sensors, electrostatic discharge (ESD) devices, and memory devices. More complex devices such as radio frequency devices, power amplifiers, power management devices, antennas, arrays, sensors, and microelectromechanical systems (MEMS) devices may also be formed on the interposer 1504. The package-on-interposer structure 1536 may take the form of any of the package-on-interposer structures known in the art.

The IC device assembly 1500 may include an IC package 1524 coupled to the first face 1540 of the circuit board 1502 by coupling components 1522. The coupling components 1522 may take the form of any of the examples discussed above with reference to the coupling components 1516, and the IC package 1524 may take the form of any of the examples discussed above with reference to the IC package 1520.

The IC device assembly 1500 illustrated in FIG. 15 includes a package-on-package structure 1534 coupled to the second face 1542 of the circuit board 1502 by coupling components 1528. The package-on-package structure 1534 may include a first IC package 1526 and a second IC package 1532 coupled together by coupling components 1530 such that the first IC package 1526 is disposed between the circuit board 1502 and the second IC package 1532. The coupling components 1528, 1530 may take the form of any of the examples of the coupling components 1516 discussed above, and the IC packages 1526, 1532 may take the form of any of the examples of the IC package 1520 discussed above. The package-on-package structure 1534 may be configured in accordance with any of the package-on-package structures known in the art.

FIG. 16 is a block diagram of an example electrical device 1600 that may include one or more of the example IC package 100. For example, any suitable ones of the components of the electrical device 1600 may include one or more of the device assemblies 1500, IC devices 1400, or dies 1302 disclosed herein, and may be arranged in the example IC package 100. A number of components are illustrated in FIG. 16 as included in the electrical device 1600, but any one or more of these components may be omitted or duplicated, as suitable for the application. In some examples, some or all of the components included in the electrical device 1600 may be attached to one or more motherboards. In some examples, some or all of these components are fabricated onto a single system-on-a-chip (SoC) die.

Additionally, in various examples, the electrical device 1600 may not include one or more of the components illustrated in FIG. 16, but the electrical device 1600 may include interface circuitry for coupling to the one or more components. For example, the electrical device 1600 may not include a display 1606, but may include display interface circuitry (e.g., a connector and driver circuitry) to which a display 1606 may be coupled. In another set of examples, the electrical device 1600 may not include an audio input device 1618 (e.g., microphone) or an audio output device 1608 (e.g., a speaker, a headset, earbuds, etc.), but may include audio input or output device interface circuitry (e.g., connectors and supporting circuitry) to which an audio input device 1618 or audio output device 1608 may be coupled.

The electrical device 1600 may include programmable circuitry 1602 (e.g., one or more processing devices). The programmable circuitry 1602 may include one or more digital signal processors (DSPs), application-specific integrated circuits (ASICs), central processing units (CPUs), graphics processing units (GPUs), cryptoprocessors (specialized processors that execute cryptographic algorithms within hardware), server processors, or any other suitable processing devices. The electrical device 1600 may include a memory 1604, which may itself include one or more memory devices such as volatile memory (e.g., dynamic random access memory (DRAM)), nonvolatile memory (e.g., read-only memory (ROM)), flash memory, solid state memory, and/or a hard drive. In some examples, the memory 1604 may include memory that shares a die with the programmable circuitry 1602. This memory may be used as cache memory and may include embedded dynamic random access memory (eDRAM) or spin transfer torque magnetic random access memory (STT-MRAM).

In some examples, the electrical device 1600 may include a communication chip 1612 (e.g., one or more communication chips). For example, the communication chip 1612 may be configured for managing wireless communications for the transfer of data to and from the electrical device 1600. The term "wireless" and its derivatives may be used to describe circuits, devices, systems, methods, techniques, communications channels, etc., that may communicate data through the use of modulated electromagnetic radiation through a nonsolid medium. The term does not imply that the associated devices do not contain any wires, although in some examples they might not.

The communication chip 1612 may implement any of a number of wireless standards or protocols, including but not limited to Institute for Electrical and Electronic Engineers (IEEE) standards including Wi-Fi (IEEE 802.11 family), IEEE 802.16 standards (e.g., IEEE 802.16-2005 Amendment), Long-Term Evolution (LTE) project along with any amendments, updates, and/or revisions (e.g., advanced LTE project, ultra mobile broadband (UMB) project (also referred to as "3GPP2"), etc.). IEEE 802.16 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 802.16 standards. The communication chip 1612 may operate in accordance with a Global System for Mobile Communication (GSM), General Packet Radio Service (GPRS), Universal Mobile Telecommunications System (UMTS), High Speed Packet Access (HSPA), Evolved HSPA (E-HSPA), or LTE network. The communication chip 1612 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). The communication chip 1612 may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. The communication chip 1612 may operate in accordance with other wireless protocols in other examples. The electrical device 1600 may include an antenna 1622 to facilitate wireless communications and/or to receive other wireless communications (such as AM or FM radio transmissions).

In some examples, the communication chip 1612 may manage wired communications, such as electrical, optical, or any other suitable communication protocols (e.g., the Ethernet). As noted above, the communication chip 1612 may include multiple communication chips. For instance, a first communication chip 1612 may be dedicated to shorter-range wireless communications such as Wi-Fi or Bluetooth, and a second communication chip 1612 may be dedicated to longer-range wireless communications such as global positioning system (GPS), EDGE, GPRS, CDMA, WiMAX, LTE, EV-DO, or others. In some examples, a first communication chip 1612 may be dedicated to wireless communications, and a second communication chip 1612 may be dedicated to wired communications.

The electrical device 1600 may include battery/power circuitry 1614. The battery/power circuitry 1614 may include one or more energy storage devices (e.g., batteries or capacitors) and/or circuitry for coupling components of the electrical device 1600 to an energy source separate from the electrical device 1600 (e.g., AC line power).

The electrical device 1600 may include a display 1606 (or corresponding interface circuitry, as discussed above). The display 1606 may include any visual indicators, such as a heads-up display, a computer monitor, a projector, a touchscreen display, a liquid crystal display (LCD), a light-emitting diode display, or a flat panel display.

The electrical device 1600 may include an audio output device 1608 (or corresponding interface circuitry, as discussed above). The audio output device 1608 may include any device that generates an audible indicator, such as speakers, headsets, or earbuds.

The electrical device 1600 may include an audio input device 1618 (or corresponding interface circuitry, as discussed above). The audio input device 1618 may include any device that generates a signal representative of a sound, such as microphones, microphone arrays, or digital instruments (e.g., instruments having a musical instrument digital interface (MIDI) output).

The electrical device 1600 may include GPS circuitry 1616. The GPS circuitry 1616 may be in communication with a satellite-based system and may receive a location of the electrical device 1600, as known in the art.

The electrical device 1600 may include any other output device 1610 (or corresponding interface circuitry, as discussed above). Examples of the other output device 1610 may include an audio codec, a video codec, a printer, a wired or wireless transmitter for providing information to other devices, or an additional storage device.

The electrical device 1600 may include any other input device 1620 (or corresponding interface circuitry, as discussed above). Examples of the other input device 1620 may include an accelerometer, a gyroscope, a compass, an image capture device, a keyboard, a cursor control device such as a mouse, a stylus, a touchpad, a bar code reader, a Quick Response (QR) code reader, any sensor, or a radio frequency identification (RFID) reader.

The electrical device 1600 may have any desired form factor, such as a hand-held or mobile electrical device (e.g., a cell phone, a smart phone, a mobile internet device, a music player, a tablet computer, a laptop computer, a netbook computer, an ultrabook computer, a personal digital assistant (PDA), an ultra mobile personal computer, etc.), a desktop electrical device, a server or other networked computing component, a printer, a scanner, a monitor, a set-top box, an entertainment control unit, a vehicle control unit, a digital camera, a digital video recorder, or a wearable electrical device. In some examples, the electrical device 1600 may be any other electronic device that processes data.

"Including" and "comprising" (and all forms and tenses thereof) are used herein to be open ended terms. Thus, whenever a claim employs any form of "include" or "comprise" (e.g., comprises, includes, comprising, including, having, etc.) as a preamble or within a claim recitation of any kind, it is to be understood that additional elements, terms, etc., may be present without falling outside the scope of the corresponding claim or recitation. As used herein, when the phrase "at least" is used as the transition term in, for example, a preamble of a claim, it is open-ended in the same manner as the term "comprising" and "including" are open ended. The term "and/or" when used, for example, in a form such as A, B, and/or C refers to any combination or subset of A, B, C such as (1) A alone, (2) B alone, (3) C alone, (4) A with B, (5) A with C, (6) B with C, or (7) A with B and with C. As used herein in the context of describing structures, components, items, objects and/or things, the phrase "at least one of A and B" is intended to refer to implementations including any of (1) at least one A, (2) at least one B, or (3) at least one A and at least one B. Similarly, as used herein in the context of describing structures, components, items, objects and/or things, the phrase "at least one of A or B" is intended to refer to implementations including any of (1) at least one A, (2) at least one B, or (3) at least one A and at least one B. As used herein in the context of describing the performance or execution of processes, instructions, actions, activities, etc., the phrase "at least one of A and B" is intended to refer to implementations including any of (1) at least one A, (2) at least one B, or (3) at least one A and at least one B. Similarly, as used herein in the context of describing the performance or execution of processes, instructions, actions, activities, etc., the phrase "at least one of A or B" is intended to refer to implementations including any of (1) at least one A, (2) at least one B, or (3) at least one A and at least one B.

As used herein, singular references (e.g., "a", "an", "first", "second", etc.) do not exclude a plurality. The term "a" or "an" object, as used herein, refers to one or more of that object. The terms "a" (or "an"), "one or more", and "at least one" are used interchangeably herein. Furthermore, although individually listed, a plurality of means, elements, or actions may be implemented by, e.g., the same entity or object. Additionally, although individual features may be included in different examples or claims, these may possibly be combined, and the inclusion in different examples or claims does not imply that a combination of features is not feasible and/or advantageous.

As used herein, unless otherwise stated, the term "above" describes the relationship of two parts relative to Earth. A first part is above a second part, if the second part has at least one part between Earth and the first part. Likewise, as used herein, a first part is "below" a second part when the first part is closer to the Earth than the second part. As noted above, a first part can be above or below a second part with one or more of: other parts therebetween, without other parts therebetween, with the first and second parts touching, or without the first and second parts being in direct contact with one another.

Notwithstanding the foregoing, in the case of referencing a semiconductor device (e.g., a transistor), a semiconductor die containing a semiconductor device, and/or an integrated circuit (IC) package containing a semiconductor die during fabrication or manufacturing, "above" is not with reference to Earth, but instead is with reference to an underlying substrate on which relevant components are fabricated, assembled, mounted, supported, or otherwise provided. Thus, as used herein and unless otherwise stated or implied from the context, a first component within a semiconductor die (e.g., a transistor or other semiconductor device) is "above" a second component within the semiconductor die when the first component is farther away from a substrate (e.g., a semiconductor wafer) during fabrication/manufacturing than the second component on which the two components are fabricated or otherwise provided. Similarly, unless otherwise stated or implied from the context, a first component within an IC package (e.g., a semiconductor die) is "above" a second component within the IC package during fabrication when the first component is farther away from a printed circuit board (PCB) to which the IC package is to be mounted or attached. It is to be understood that semiconductor devices are often used in orientation different than their orientation during fabrication. Thus, when referring to a semiconductor device (e.g., a transistor), a semiconductor die containing a semiconductor device, and/or an integrated circuit (IC) package containing a semiconductor die during use, the definition of "above" in the preceding paragraph (i.e., the term "above" describes the relationship of two parts relative to Earth) will likely govern based on the usage context.

As used in this patent, stating that any part (e.g., a layer, film, area, region, or plate) is in any way on (e.g., positioned on, located on, disposed on, or formed on, etc.) another part, indicates that the referenced part is either in contact with the other part, or that the referenced part is above the other part with one or more intermediate part(s) located therebetween.

As used herein, connection references (e.g., attached, coupled, connected, and joined) may include intermediate members between the elements referenced by the connection reference and/or relative movement between those elements unless otherwise indicated. As such, connection references do not necessarily infer that two elements are directly connected and/or in fixed relation to each other. As used herein, stating that any part is in "contact" with another part is defined to mean that there is no intermediate part between the two parts.

Unless specifically stated otherwise, descriptors such as "first," "second," "third," etc., are used herein without imputing or otherwise indicating any meaning of priority, physical order, arrangement in a list, and/or ordering in any way, but are merely used as labels and/or arbitrary names to distinguish elements for ease of understanding the disclosed examples. In some examples, the descriptor "first" may be used to refer to an element in the detailed description, while the same element may be referred to in a claim with a different descriptor such as "second" or "third." In such instances, it should be understood that such descriptors are used merely for identifying those elements distinctly within the context of the discussion (e.g., within a claim) in which the elements might, for example, otherwise share a same name.

As used herein, "approximately" and "about" modify their subjects/values to recognize the potential presence of variations that occur in real world applications. For example, "approximately" and "about" may modify dimensions that may not be exact due to manufacturing tolerances and/or other real world imperfections as will be understood by persons of ordinary skill in the art. For example, "approximately" and "about" may indicate such dimensions may be within a tolerance range of +/- 10% unless otherwise specified herein.

As used herein "substantially real time" refers to occurrence in a near instantaneous manner recognizing there may be real world delays for computing time, transmission, etc. Thus, unless otherwise specified, "substantially real time" refers to real time + 1 second.

As used herein, the phrase "in communication," including variations thereof, encompasses direct communication and/or indirect communication through one or more intermediary components, and does not require direct physical (e.g., wired) communication and/or constant communication, but rather additionally includes selective communication at periodic intervals, scheduled intervals, aperiodic intervals, and/or one-time events.

As used herein, "programmable circuitry" is defined to include (i) one or more special purpose electrical circuits (e.g., an application specific circuit (ASIC)) structured to perform specific operation(s) and including one or more semiconductor-based logic devices (e.g., electrical hardware implemented by one or more transistors), and/or (ii) one or more general purpose semiconductor-based electrical circuits programmable with instructions to perform specific functions(s) and/or operation(s) and including one or more semiconductor-based logic devices (e.g., electrical hardware implemented by one or more transistors). Examples of programmable circuitry include programmable microprocessors such as Central Processor Units (CPUs) that may execute first instructions to perform one or more operations and/or functions, Field Programmable Gate Arrays (FPGAs) that may be programmed with second instructions to cause configuration and/or structuring of the FPGAs to instantiate one or more operations and/or functions corresponding to the first instructions, Graphics Processor Units (GPUs) that may execute first instructions to perform one or more operations and/or functions, Digital Signal Processors (DSPs) that may execute first instructions to perform one or more operations and/or functions, XPUs, Network Processing Units (NPUs) one or more microcontrollers that may execute first instructions to perform one or more operations and/or functions and/or integrated circuits such as Application Specific Integrated Circuits (ASICs). For example, an XPU may be implemented by a heterogeneous computing system including multiple types of programmable circuitry (e.g., one or more FPGAs, one or more CPUs, one or more GPUs, one or more NPUs, one or more DSPs, etc., and/or any combination(s) thereof), and orchestration technology (e.g., application programming interface(s) (API(s)) that may assign computing task(s) to whichever one(s) of the multiple types of programmable circuitry is/are suited and available to perform the computing task(s).

As used herein integrated circuit/circuitry is defined as one or more semiconductor packages containing one or more circuit elements such as transistors, capacitors, inductors, resistors, current paths, diodes, etc. For example an integrated circuit may be implemented as one or more of an ASIC, an FPGA, a chip, a microchip, programmable circuitry, a semiconductor substrate coupling multiple circuit elements, a system on chip (SoC), etc.

From the foregoing, it will be appreciated that example systems, apparatus, articles of manufacture, and methods have been disclosed that involve package substrates that include substrate cores containing a stack of discrete glass layers or glass cores having different CTEs. The different CTEs define a CTE gradient that reduces stress within package substrates and, specifically, mitigates against seware failures that are known to arise in substrate with a single, solid glass core with a single CTE. As a result, examples disclosed herein improve yield loss in the fabrication of package substrates and also improve the reliability and/or useful life of IC packages relative to known techniques. Furthermore, examples disclosed herein include an interconnect bridge embedded within such substrate cores (e.g., within one or more glass layer in the stack of glass cores). Embedding an interconnect bridge with a glass core can provide die-to-die interconnects without the need for a thick build-up region on top of the package substrate. Reducing and/or eliminating the need for a build-up region outside of the substrate core is achieved by metallization between the different layers in the stack of glass cores that functions as redistribution layers for the package substrate.

Further examples and combinations thereof include the following:
Example 1 includes a substrate for in integrated circuit package, the substrate comprising a first glass layer having a cavity defined therein, a second glass layer different from the first glass layer, and an interconnect bridge at least partially in the cavity, the interconnect bridge to electrically couple a first semiconductor die to a second semiconductor die.
Example 2 includes the substrate of example 1, wherein the first glass layer has a first coefficient of thermal expansion (CTE), and the second glass layer has a second CTE, the second CTE different from the first CTE.
Example 3 includes the substrate of example 2, further including a third glass layer having a third CTE.
Example 4 includes the substrate of any one of examples 1-3, wherein the interconnect bridge includes silicon.
Example 5 includes the substrate of any one of examples 1-4, wherein first glass layer is closer to the first semiconductor die than the second glass layer is to the first semiconductor die, and the interconnect bridge includes a through-silicon via to electrically connect the first semiconductor die to a through-glass via in the second glass layer.
Example 6 includes the substrate of any one of examples 1-5, wherein first glass layer has a first surface that faces toward the first semiconductor die, and the interconnect bridge has a second surface that faces toward the first semiconductor die, the second surface substantially flush with the first surface.
Example 7 includes the substrate of any one of examples 1-6, wherein first glass layer has a first thickness, and the interconnect bridge has a second thickness, the second thickness approximately equal to the first thickness.
Example 8 includes the substrate of any one of examples 1-6, wherein first glass layer has a first thickness, and the interconnect bridge has a second thickness, the second thickness less than the first thickness.
Example 9 includes the substrate of any one of examples 1-6, wherein first glass layer has a first thickness, and the interconnect bridge has a second thickness, the second thickness greater than the first thickness.
Example 10 includes the substrate of any one of examples 1-9, wherein first glass layer is spaced apart from the second glass layer.
Example 11 includes the substrate of any one of examples 1-10, further including a dielectric material between the first glass layer and the second glass layer.
Example 12 includes the substrate of example 11, wherein the dielectric material has a lower modulus of elasticity than the first glass layer.
Example 13 includes the substrate of any one of examples 11 or 12, further including a redistribution layer including metal within the dielectric material.
Example 14 includes the substrate of any one of examples 1-13, further including a dielectric material within the cavity, the dielectric material to at least partially surround the interconnect bridge.
Example 15 includes an integrated circuit (IC) package comprising a first semiconductor die, a second semiconductor die adjacent the first semiconductor die, a package substrate including a stack of multiple glass layers, and an interconnect die in at least one layer of multiple glass layers, the first semiconductor die electrically coupled to the second semiconductor die through the interconnect die.
Example 16 includes the IC package of example 15, wherein different ones of the glass layers have different coefficients of thermal expansion (CTEs).
Example 17 includes the IC package of example 16, wherein differences in the different CTEs corresponds to incremental changes in CTE across a larger span of CTE values.
Example 18 includes an apparatus comprising a first semiconductor chip, a second semiconductor chip, and a package substrate, the first and second semiconductor chips mounted to the package substrate, the package substrate including distinct glass sheets, and a silicon-based bridge within an opening in at least a first one of the glass sheets, the silicon-based bridge electrically coupling the first and second semiconductor chips.
Example 19 includes the apparatus of example 18, wherein the first one of the glass sheets has a coefficient of thermal expansion (CTE) different from a CTE of a second one of the glass sheets.
Example 20 includes the apparatus of any one of examples 18 or 19, wherein the first one of the glass sheets is separated from a second one of the glass sheets by an intervening layer of dielectric material.
The following claims are hereby incorporated into this Detailed Description by this reference. Although certain example systems, apparatus, articles of manufacture, and methods have been disclosed herein, the scope of coverage of this patent is not limited thereto. On the contrary, this patent covers all systems, apparatus, articles of manufacture, and methods fairly falling within the scope of the claims of this patent.

## Claims

1. A substrate for an integrated circuit package, the substrate comprising:
a first glass layer having a cavity defined therein;
a second glass layer different from the first glass layer; and
an interconnect bridge at least partly in the cavity, the interconnect bridge to electrically couple a first semiconductor die to a second semiconductor die.

2. The substrate of claim 1, wherein the first glass layer has a first coefficient of thermal expansion (CTE), and the second glass layer has a second CTE, the second CTE different from the first CTE.

3. The substrate of claim 2, further including a third glass layer having a third CTE.

4. The substrate of any one of claims 1-3, wherein the interconnect bridge includes silicon.

5. The substrate of any one of claims 1-4, wherein first glass layer is closer to the first semiconductor die than the second glass layer is to the first semiconductor die, and the interconnect bridge includes a through-silicon via to electrically connect the first semiconductor die to a through-glass via in the second glass layer.

6. The substrate of any one of claims 1-5, wherein first glass layer has a first surface that faces toward the first semiconductor die, and the interconnect bridge has a second surface that faces toward the first semiconductor die, the second surface substantially flush with the first surface.

7. The substrate of any one of claims 1-6, wherein the first glass layer has a first thickness, and the interconnect bridge has a second thickness, the second thickness approximately equal to the first thickness.

8. The substrate of any one of claims 1-6, wherein the first glass layer has a first thickness, and the interconnect bridge has a second thickness, the second thickness less than the first thickness.

9. The substrate of any one of claims 1-6, wherein the first glass layer has a first thickness, and the interconnect bridge has a second thickness, the second thickness greater than the first thickness.

10. The substrate of any one of claims 1-9, wherein first glass layer is spaced apart from the second glass layer.

11. The substrate of any one of claims 1-10, further including a dielectric material between the first glass layer and the second glass layer.

12. The substrate of claim 11, wherein the dielectric material has a lower modulus of elasticity than the first glass layer.

13. The substrate of any one of claims 11-12, further including a redistribution layer including metal within the dielectric material.

14. The substrate of any one of claims 1-13, further including a dielectric material within the cavity, the dielectric material to at least partially surround the interconnect bridge.

15. The substrate of any one of claims 1-14, further including a stack of multiple glass layers, the stack including the first and second glass layers, wherein different ones of the glass layers have different coefficients of thermal expansion (CTEs), and differences in the different CTEs correspond to incremental changes in CTE across a larger span of CTE values.
